# EUROPEAN PATENT SPECIFICATION

(11) **EP 4 378 883 B1**
(45) Date of publication and mention of the grant of the patent: **24.12.2025**
(21) Application number: 23207483.1
(22) Date of filing: 02.11.2023
(51) Int. Cl.: B81C 1/00

(54) **MEMS TRANSDUCER DEVICE FOR HIGH-FREQUENCY APPLICATIONS, AND MANUFACTURING METHOD**
MEMS-WANDLERVORRICHTUNG FÜR HOCHFREQUENZANWENDUNGEN UND HERSTELLUNGSVERFAHREN
DISPOSITIF DE TRANSDUCTEUR MEMS POUR APPLICATIONS HAUTE FRÉQUENCE ET PROCÉDÉ DE FABRICATION

(30) Priority: 25.11.2022 IT 202200024411
(43) Date of publication of application: 05.06.2024
(73) Proprietor: STMicroelectronics S.r.l., 20864 Agrate Brianza (MB) (IT)
(72) Inventor: GIUSTI, Domenico, 20867 CAPONAGO (MB) (IT); QUAGLIA, Fabio, 27050 PIZZALE (PV) (IT); FERRERA, Marco, 20863 CONCOREZZO (MB) (IT); PRELINI, Carlo Luigi, 20822 SEVESO (MB) (IT); SAVOIA, Alessandro Stuart, 00135 ROMA (IT)
(74) Representative: Studio Torta S.p.A.

(56) References cited:
- EP-A1- 3 599 217

## Description

The present invention relates to a micro-electro-mechanical (MEMS) device, in particular to an electroacoustic transducer device, and to a manufacturing method of the micro-electro-mechanical device.

As is known, numerous ultrasonic sensors are currently available, which are for transmitting and receiving acoustic waves with frequencies higher than 20 kHz. Typically, an ultrasound sensor comprises, in addition to an electroacoustic transducer, a circuitry for driving the transducer, as well as for amplifying the electrical signals generated by the same transducer following the reception of acoustic echo signals. The transducer therefore acts as both an acoustic emitter and an acoustic receiver, in different time periods.

Referring to stimulus acoustic signals and response acoustic signals to indicate, respectively, acoustic signals (or beams) transmitted by the transducer and acoustic signals (or beams) impinging on the transducer, for example following the reflection of the stimulus acoustic signals by an obstacle, the need is known, for example in the ultrasound field, to be able to focus the stimulus acoustic signals. In order to control the emission of stimulus acoustic signals into space, the technique is known which provides for having a plurality of transducers, each of which emits spherical acoustic waves, and for controlling these transducers with drive signals suitably phase-shifted with each other, so that the sum of the stimulus acoustic signals generated by the transducers forms an acoustic beam having the desired spatial distribution.

This having been said, in order to increase performances, in particular as regards echo amplification, the transducers, typically formed by corresponding MEMS devices arranged according to a matrix, need to be arranged as close as possible to the electronic circuitry, and in particular to the part of electronic circuitry responsible for amplifying the electrical signals generated by the transducers. However, this need clashes with the high number of transducers (in the order of thousands) typically used.

In practice, since each transducer is coupled to a respective application-specific integrated circuit (ASIC), which forms the driver circuit and the receiver associated with the transducer, thousands of connections present between the transducers and the ASIC circuits connected thereto need to be dealt with, by controlling the delays introduced by the different channels (each channel being understood as formed by a transducer, the corresponding driver circuit and the corresponding receiver), as well as the jitter present between the different channels.

This having been said, manufacturing processes are currently known which provide for processing a first and a second semiconductive wafer, so as to form, in the first wafer, a plurality of transducers, as well as to form, in the second wafer, a plurality of ASIC circuits. Subsequently, the first and the second wafers are coupled to each other, such that the transducers are coupled to the corresponding ASIC circuits. This process, however, is characterized by a reduced flexibility, since it provides for the adoption of a single manufacturing technology for both the driver circuits and the reception circuits. Furthermore, this manufacturing process does not allow the ASIC circuits to be tested until the same process has been ended. Again, this manufacturing process requires that the pitch of the electrical connection pads in the first and the second wafers be the same.

The patent document EP3599217 discusses that, to increase the performances and in particular as regards the echo amplification, it is advisable that the transducers, (typically formed by corresponding MEMS devices arranged according to a matrix) are arranged as close as possible to the electronic circuitry, and in particular to the part of the electronic circuitry which has the function of amplifying the electrical signals generated by the transducers. The authors of this patent document provide a manufacturing process for MEMS devices which partially overcomes the drawbacks of the prior art.

However, the known manufacturing process does not allow to manufacture broadband PMUTs above 4 MHz due to some process limitations, including for example the minimum cavity-cavity distance and the minimum thickness of the membrane.

The aim of the present invention is therefore to provide a MEMS device and a manufacturing method of the MEMS device, to at least partially overcome the drawbacks of the prior art.

According to the present invention, a MEMS device and a manufacturing method of the MEMS device are provided, as defined in the attached claims.

For a better understanding of the present invention, preferred embodiments thereof are now described, purely by way of non-limiting example, with reference to the attached drawings, wherein:
- Figure 1A schematically shows a cross-section of a MEMS device for electroacoustic transductions, in particular a PMUT;
- Figure 1B schematically shows a perspective view of a portion of the MEMS device of Figure 1A;
- Figures 2A-2D illustrate sections of electrical coupling elements of the MEMS device of Figure 1A and of Figure 1B, according to respective embodiments;
- Figures 3 and 4 show respective embodiments of mutual arrangement patterns of transducers and electrical coupling elements of the MEMS device of Figure 1A and of Figure 1B;
- Figures 5A-5M illustrate manufacturing steps of the MEMS device of Figure 1A; and
- Figure 6 illustrates a transducer implementable in the MEMS device of Figures 1A-1B and 5F-5M.

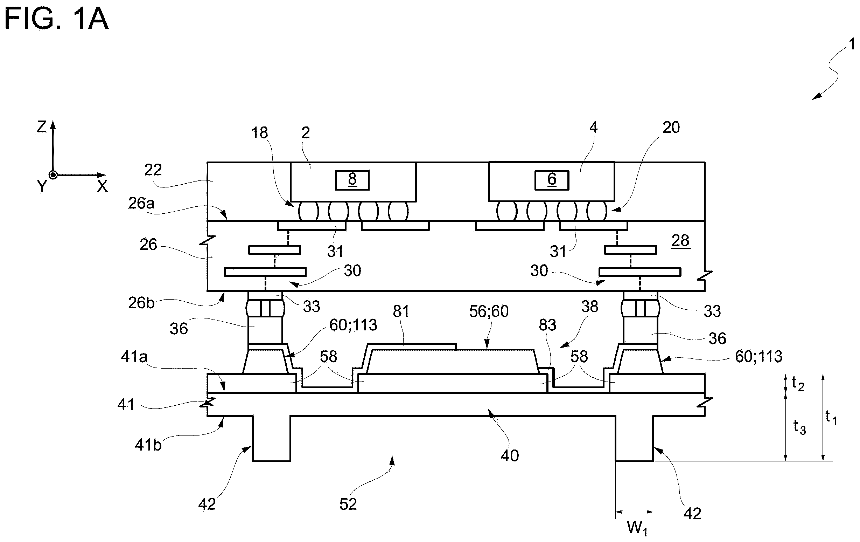

Figure 1A shows a portion of a MEMS device 1, particularly an electroacoustic device, even more particularly an ultrasonic transducer device (PMUT), in a triaxial system of axes X, Y, Z orthogonal to each other. The view of Figure 1A is in-section on the XZ plane.

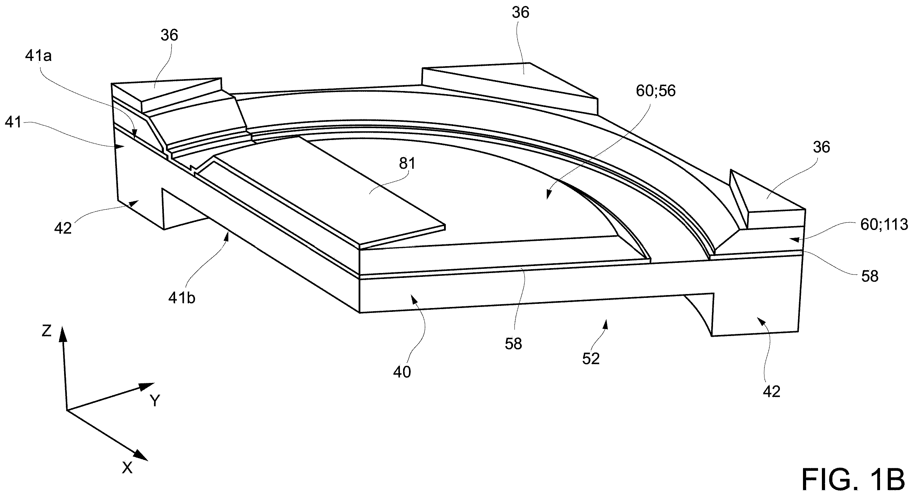

Figure 1B shows in perspective view a detail of the MEMS device 1 of Figure 1A (some elements are not present, for simplicity of representation and better clarity), in the triaxial system XYZ.

Elements common between Figures 1A-1B are identified with the same reference numerals.

With joint reference to Figures 1A and 1B, the electroacoustic device 1 comprises a first and a second die 2, 4, having a first and a second integrated circuit 6, 8, respectively, formed therein, formed for example by known ASIC circuits. Each of the first and the second integrated circuits 6, 8 comprises a respective transmission circuit and a respective reception circuit of respective actuation and detection signals. The transmission circuit, as better illustrated below, is configured to generate and transmit a control signal (actuation) of an actuator or transducer of the device 1; the reception circuit, as better illustrated hereinbelow, is configured to receive and process a signal transduced by a transducer of the device 1. In one embodiment, one of the transmission circuit and the reception circuit may be absent.

In each of the first and the second integrated circuits 6, 8, the corresponding transmission and reception circuits are electrically connected to a corresponding plurality of metal "bumps", indicated by 18 and 20, respectively, and also known as microbumps. Again, in a per se known manner, the bumps 18, 20 are electrically connected to metallizations of the corresponding dice 2, 4, for example through respective electric contact pads.

The electroacoustic device 1 also comprises a coating region 22, which is formed for example by an epoxy resin and incorporates the first and the second dice 2, 4.

The electroacoustic device 1 further comprises a redistribution structure 26, which comprises a dielectric region 28 which accommodates a plurality of conductive paths 30 (shown qualitatively). The redistribution structure 26 is delimited by a first and a second side 26a, 26b, opposite to each other along the Z axis; the conductive paths 30 extend between the first and the second sides, reaching the first and the second sides. At the sides 26a, 26b conductive pads 31, 33 are present having the various conductive paths 30 electrically connected thereto. The dielectric region 28 is formed, for example, by polyimide (or, for example, polyamide or a resin with glass fibers). The conductive paths 30 are typically of metal material, such as for example copper.

The electroacoustic device 1 further comprises a plurality of pillars 36 of metal material (for example of gold, or copper, or tin or other metal material).

The electroacoustic device 1 further comprises a transduction module, or structure, 38, electrically and physically coupled to the redistribution structure 26 by the pillars 36.

The transduction structure 38 comprises a structural body 41 having a first surface 41a opposite to a second surface 41b. The structural body 41 comprises, as better described below, one or more semiconductor material layers alternating with one or more insulating material layers. In particular, the structural body 41 has, at the second surface 41b, thick, undeformable portions 42 separated from each other by a plurality of recesses 52. In other words, the structural body 41 has a thickness, along the Z axis, which is variable, including a first value t₁ at the thick portions 42 and a second value t₂<t₁ at the recesses 52.

The recesses 52 have an extension, along the Z axis, equal to t₃, wherein t₃ is comprised between 5 µm and 400 µm. In other words, the dimension, along the Z axis, of each thick portion 42 is t₃=t₁-t₂.

The extension, along the X axis, of each of the thick portions 42 is w₁ comprised between 10 and 30 µm, for example equal to 20 µm.

At the first surface 41a the pillars 36 extend, which protrude from the structural body 41 along the Z axis.

The portions of the structural body 41 having thickness t₂ (i.e. the portions suspended on corresponding recesses 52, between two adjacent thick portions 42) form respective membranes 40, while all of the thick regions 42 form a frame having the membranes 40 fixed thereto.

The membranes 40 may have a thickness t₂ comprised for example between 3 µm and 10 µm, in particular equal to about 4 µm.

The electroacoustic device 1 further comprises a plurality of transducers 56. In this context, the transducer 56 may be operated to generate a deflection of the respective membrane 40 or be used to detect a deformation of the respective membrane 40. By way of example, without thereby losing generality, only the operation of generating the deflection of the membrane will be considered hereinbelow and the transducers 56 will be referred to as actuators 56. The electroacoustic device 1 therefore comprises an actuator 56 for each membrane 40. Each actuator 56 extends on, and in contact with, the corresponding membrane 40. Each actuator 56 is integral with the respective membrane 40. An insulating layer 58, for example of silicon oxide, extends on the surface 41a, below each actuator 56. The insulating layer 58 contributes to thickening the respective membrane 40 and therefore this thickness is taken into account during the design step of the value t₂.

The membrane 40 and the respective actuator 56 form, as a whole, a transducer device, configured to transduce a received electrical signal (control signal) into a mechanical movement and, therefore, into an acoustic wave. The reverse transduction is, as said, possible, additionally or alternatively, according to the conditions of use of the electroacoustic device 1.

In greater detail, each actuator 56 comprises a stack 60, including a respective piezoelectric region (e.g., of PZT) and a pair of drive electrodes configured to bias the piezoelectric region in order to generate a corresponding deformation of the piezoelectric region.

Each actuator 56 is surrounded (partially or completely, in respective embodiments) by a stiffening structure 113, having the pillars 36 extending thereon. In one embodiment, the stiffening structure 113 is formed by the same stack 60 as the actuator 56, in order to simplify the process steps. However, it is apparent that the stiffening structure 113 may be of other materials, for example semiconductor or insulating materials, or a stack including such materials. The stiffening structure 113 has a thickness along the Z axis, comprised between 1 µm and 50 µm.

Each actuator 56 is electrically coupled, through respective conductive tracks 81, 83, to the pillars 36. Since in the case of a piezoelectric actuator two actuation electrodes (a top electrode and a bottom electrode with respect to the PZT layer) are provided, in a per se known manner, Figure 1A illustrates a conductive track 81, 83 for each top and, respectively, bottom electrode. The conductive tracks 81, 83 partially extend on the membrane 40 laterally to the actuator 56, up to reaching and contacting the respective pillars 36 downwardly.

Through the conductive tracks 81, 83 and the pillars 36, each actuator 56 is electrically coupled to the conductive paths 30 of the redistribution structure 26 and, therefore, to corresponding bumps 18, 20 of the first and the second dice 2, 4. In this manner, each actuator 56 is for receiving electric control signals from the dice 2, 4, which cause corresponding deformations of the membrane 40 mechanically coupled to said actuator 56, with resulting generation of an acoustic wave; furthermore, the deformation of the membrane 40, due to the impingement (for example) of an acoustic echo signal thereon, causes a corresponding deformation of the actuator 56, which generates an electric response signal, which is sent and received by the reception circuit of the dice 2, 4, which may process it (and subsequently may provide a corresponding output signal to an external processor).

In one embodiment, each actuator 56 is connected to both the transmission circuit and the reception circuit of the corresponding die 2, 4.

In a further embodiment, the transmission and reception circuits of a die 2, 4 may manage multiple transducers 56.

Furthermore, in each die 2, 4, protection mechanisms of the reception circuit may be implemented, during the transmission step; alternatively, the transmission and reception signals may be conveyed to/from the actuator 56 through two different pillars 36.

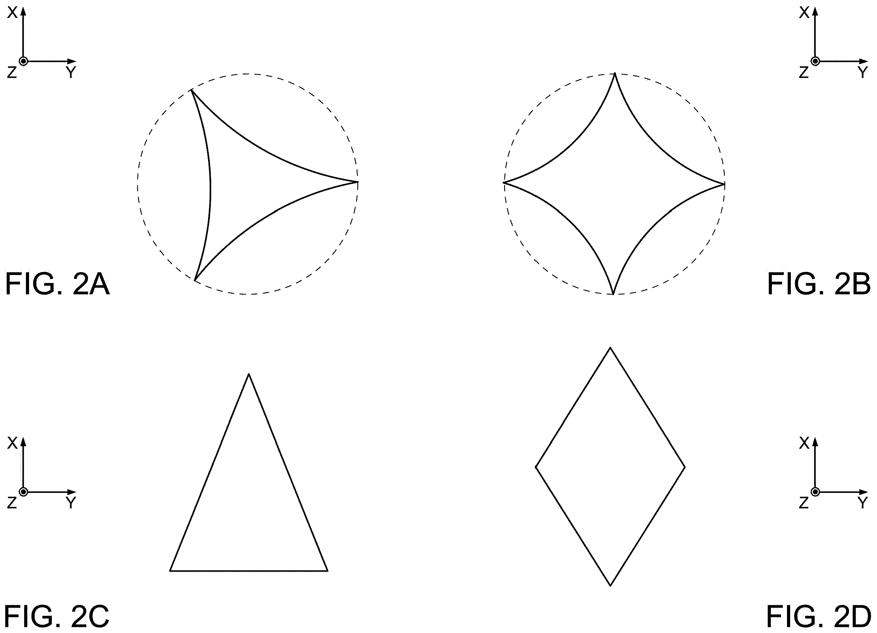

In one embodiment of the present invention, each pillar 36 has a section (on the XY plane) with a shape of:
hypocycloid with three cusps (Figure 2A), also referred to as deltoid;
hypocycloid with four cusps (Figure 2B), also referred to as astroid;
triangle (Figure 2C), in particular equilateral triangle or isosceles triangle;
quadrangular or diamond-like (Figure 2D), i.e. a quadrilateral which has two pairs of consecutive, congruent sides, or a polygon which has four sides and which has two pairs of consecutive sides having the same measure; this polygon may also be concave or convex.

With reference to Figures 2A and 2B, it is observed that the hypocycloid is defined as the curve generated by a point of a circumference which rolls on the inner part of another circumference. When the pillars 36 have this shape, in sectional view, the dimensions of the diameter of the circumference which contains the relative hypocycloid are comprised between 3 µm and 100 µm. In other words, in this case, the pillars 36 have a maximum dimension, on the XY plane, comprised between the aforementioned diameter values.

With reference to Figure 2C, when the pillars 36 have a triangular section, the dimensions of this triangle may be chosen in such a way that it is inscribable in a circumference having a diameter identified with reference to Figures 2A and 2B. By way of further example, in the case of an equilateral triangle, it is designed with a side having a value comprised between 3 µm and 50 µm; in the case of an isosceles triangle, it is designed with base side having a value comprised between 3 µm and 50 µm; and height having a value comprised between 3 µm and 100 µm.

With reference to Figure 2D, when the pillars 36 have a quadrangular section, the dimensions of this polygon may be chosen in such a way that it is inscribable in a circumference having a diameter identified with reference to Figures 2A and 2B. By way of further example, in the case of a square section of the pillars 36, the square section is designed with a side comprised between 3 µm and 50 µm; in the case of a section having the shape of a polygon with four sides and with two pairs of consecutive sides having the same measure, these sides have a measure comprised between 3 µm and 70 µm.

Each pillar 36 is therefore a solid having a uniform section throughout all its extension along the Z axis, and with a section having a shape chosen during the design step from among the previously listed shapes (Figures 2A-2D).

In general, the function of the pillars 36 is to increase the rigidity of the structure 38, in particular of the structural body 41. Therefore, the greater the spatial extension of the overlapping portions (in top view on the XY plane) between the pillars 36 and the structural body 41 (with the intermediate presence of the stiffening structure 113), the greater the stiffness increasing effect. In general, therefore, the shape of the pillars 36 may be chosen such as to maximize these overlapping portions between the pillars 36 and the stiffening structure 113 about each actuator 56/membrane 40.

In one embodiment, each actuator 56 is associated with only two pillars 36 (to carry the respective bias signals of the two top and bottom electrodes). In this case, one of these pillars 36 may have a shape chosen from the shapes mentioned above (Figures 2A-2D), and the other pillar 36 may have a generic polygonal or curvilinear shape which follows the outer profile of the respective actuator 56/membrane 40, to maximize its own overlapping portion with the structural body 41 through the stiffening structure 113. Since each pillar 36 is configured to carry a bias signal (actuation) of the respective actuator 56, these two pillars 36 are electrically insulated from each other.

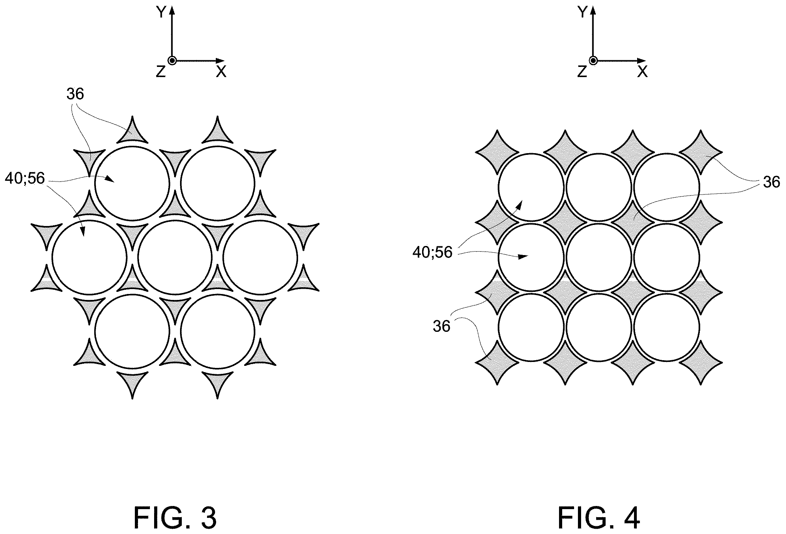

In the event that more than two pillars are present for each actuator 56, as in the examples illustrated and described below (e.g., Figure 3 and Figure 4), some of these pillars are not electrically active during use, i.e. they are not electrically coupled to any actuator 56, but have the exclusive function of stiffening the structural body 41.

In one embodiment, one of the drive electrodes of the actuator 56 (e.g., bottom electrode) is common to all the actuators 56, i.e. it extends with structural and electrical continuity throughout the entire structural body 41, in contact with all the piezoelectric elements of all the actuators 56 (and electrically insulated from further present conductive structures). In this case it is possible to provide a single bias path for this common electrode, this bias path including a single pillar 36 arranged in any region of the structural body 41 (not necessarily in proximity to a specific actuator 56). Alternatively, it is possible to provide a plurality of conductive paths for contextually biasing the common electrode.

In a different embodiment, each actuator 56 is provided with own top and bottom electrodes not shared with other actuators 56. In this case, at least two respective pillars 36 are provided for each actuator 56 to carry the bias signal to the top and bottom electrodes.

Figure 3 illustrates, in top-plan view (on the XY plane), a generic plurality of membranes 40 with respective transducers 56, arranged to form a pattern defined during the design step. In the embodiment of Figure 3, this pattern is a honeycomb pattern, i.e. the transducers 56 arranged along rows which extend along the X axis and which are parallel to each other along the Y axis; however the transducers 56 are not aligned along columns parallel to the Y axis.

In a further embodiment, Figure 4, this pattern is a matrix wherein the transducers 56 are arranged to form rows along the X axis and columns along the Y axis. Each transducer 56 (matrix 40) is located at the intersection of a respective row and a respective column.

Although in Figures 3 and 4 the pillars have a hypocycloid-shaped section with three and, respectively, four cusps, this shape has not to be understood as limiting. Other shapes are possible (see Figures 2A-2D and in general the previous description). The transducers 56 are arranged in vicinity (adjacent) to each other, to form the aforementioned arrangement pattern with the pillars 36 and the stiffening structure 113 arranged therebetween which separate the various membranes 40, according to the various possible embodiments described.

In one embodiment, each membrane 40 and each actuator 56 have a circular shape, in top-plan view (on the XY plane) . The diameter of each membrane 40 is comprised between 10 µm and 200 µm; the diameter of each actuator 56 is comprised between 7 µm and 150 µm.

The shape topology proposed for the pillars 36 allows the clamping area to be increased and the undesired bending modes to be shifted outside the operating bandwidth.

The electroacoustic device 1 may be manufactured based on the following process.

The process described refers to the manufacture of a single membrane provided with a single transducer. However, it is clear that this teaching applies to the manufacture of any plurality of membranes and relative transducers.

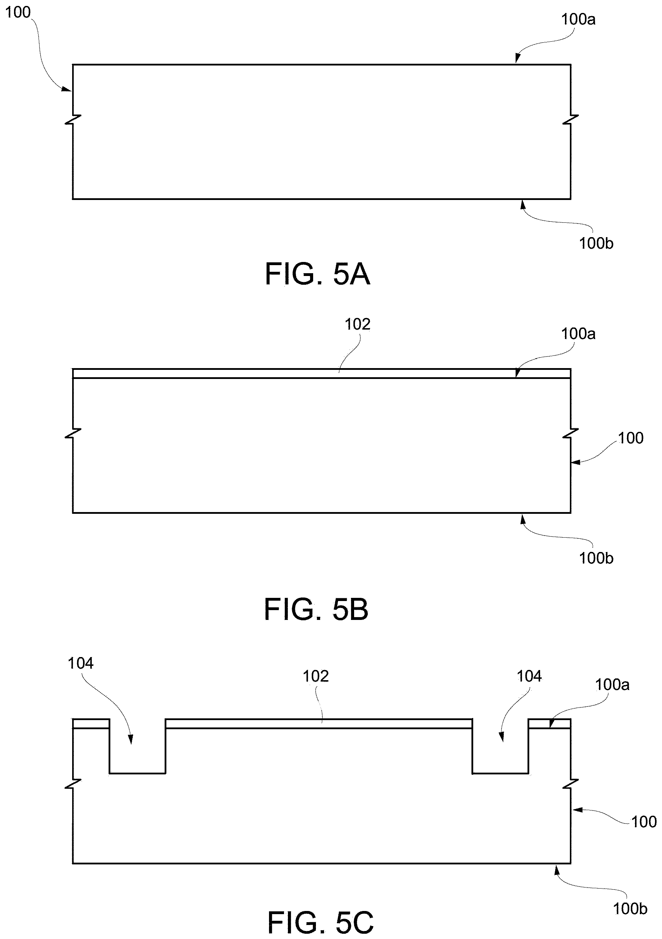

Figures 5A-5M are lateral sectional view on the XZ plane, in the same reference system of Figure 1A.

With reference to Figure 5A, a wafer 100 of semiconductor material, such as for example silicon, is arranged. The wafer 100 has a front side 100a and a rear side 100b, opposite to each other along the Z axis. The wafer 100 has, for example, a thickness, along the Z axis, equal to about 400 µm between the front side 100a and the rear side 100b.

Then, Figure 5B, a step of forming an etch stop layer 102 on the front side 100a is performed. The etch stop layer 102 is of a material that is selectively etchable with respect to the material of the wafer 100 (for example of deposited or thermally grown Silicon Oxide, or TEOS) and has a thickness comprised between about 0.3 µm and about 0.7 µm (e.g., equal to 0.5 µm).

Then, Figure 5C, selective portions of the wafer 100 (including a portion of the layer 102 and an underlying portion of the wafer 100) are removed using per se known lithography techniques, thus forming a lateral groove 104 surrounding a protruding portion 106 having, in top-view, shape and dimensions equal to those of the membrane 40 to be formed. The groove 104 ends inside the wafer 100. By way of example, the groove 104 has, in the wafer 100, a depth (along a direction parallel to the Z axis) of about 5 µm and a width (along the X axis) equal to about 5 µm.

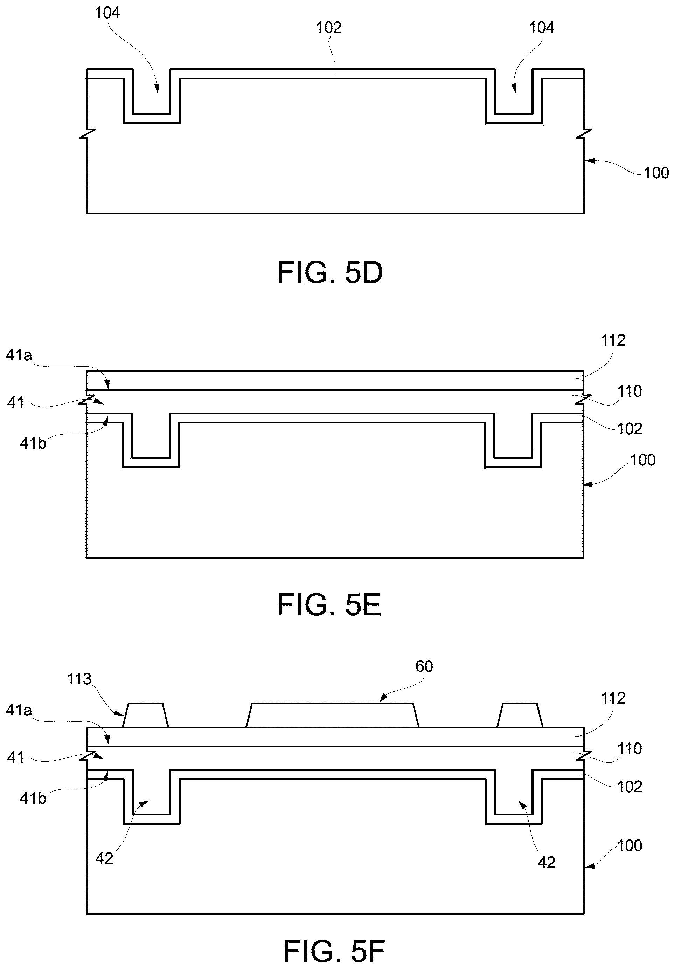

Then, Figure 5D, the etch stop layer 102 is restored inside the groove 104, for example by thermal growth of Silicon Oxide (or other material according to what has already been described with reference to Figure 5B).

Then, Figure 5E, a step of forming a structural layer 110 above the front side 100a, in particular above the etch stop layer 102, is performed. The structural layer 110 is, in one embodiment, of the same material as the wafer 100, here of Silicon. The structural layer 110 may be formed by Silicon epitaxial growth. The structural layer 110 has a thickness for example comprised between 3 µm and 100 µm; in particular equal to 10 µm. Then, the thickness of the structural layer 110 is reduced by a CMP (Chemical-Mechanical-Planarization) step, up to reaching a final thickness of the structural layer 110 comprised between 3 µm and 20 µm, in particular equal to 4 µm.

Then, Figure 5F, an insulating or dielectric layer 112 (which, hereinafter will become the layer 58 of Figure 1A, 1B), for example of Silicon Oxide, having a thickness between 0.5 µm and 3 µm, in particular equal to 1 µm, is formed on the structural layer 110.

A step of forming the actuator 56 and the stiffening structure is then performed.

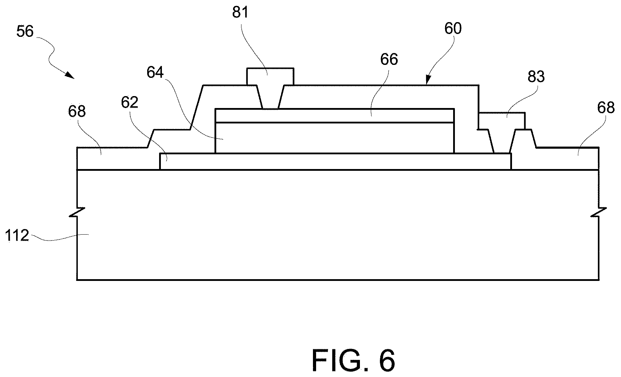

In one embodiment (exemplified in Figure 6), the actuator 56 is of the piezoelectric type and, in a per se known manner, is formed by a stack 60 comprising: a first electrode 62 of electrically conductor material, for example of titanium (Ti) or platinum (Pt); a piezoelectric material layer 64, for example PZT (Pb, Zr, TiO₃) on the first electrode 62, in electrical contact therewith; a second electrode 66, for example of TiW (titanium and tungsten alloy) on the piezoelectric layer 64, in electrical contact therewith; and a dielectric layer 68, for example of silicon oxide and silicon nitride deposited by CVD to protect the electrodes 62, 66 and the piezoelectric layer 64. In particular, the dielectric layer 68 extends on the sides of the piezoelectric material layer 64 and electrically insulates it from the conductive tracks 81, 83 which are in electrical contact respectively with the first and the second electrodes 62, 66 (and used to carry the electrical actuation signals of the membrane and/or to receive the transduced signal during the reception step).

As said, the stiffening structure 113 extends (in sectional view) laterally to the stack 60 and (in top-plan view) surrounds at least partially (completely, in the represented embodiment) the actuator 56 and the membrane 40.

The stiffening structure 113 is, in one embodiment, formed by the same stack 60 previously described, in order to optimize the manufacturing steps.

However, it is apparent that the manufacturing process may provide a stiffening structure of other material, a semiconductor and insulating material stack.

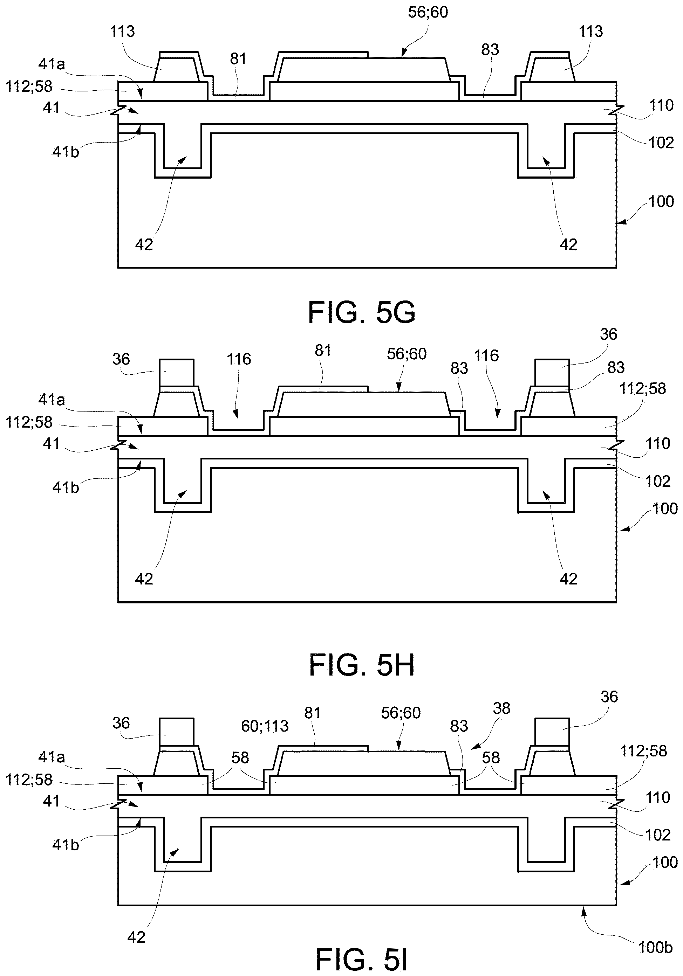

Then, Figure 5G, the insulating layer 112 is patterned so as to remove selective portions of the same which extend between the piezoelectric stack (actuator 56) and the stiffening structure 113 with the respective pillars 36. Trenches 116 are thus formed which extend through the insulating layer 112 throughout the entire thickness of the same, up to reaching the underlying structural layer 110. The layer 58 of Figure 1A, 1B is thus formed.

The conductive tracks 81, 83, of metal material, are formed in this step, in a per se evident manner, by deposition and lithography steps.

Then, Figure 5H, the pillars 36 are formed above the stiffening structure 113 and the respective conductive tracks 81, 83. The step of forming the pillars 36 comprises depositing a metal material layer, for example gold, and performing lithography and etching steps of the metal layer using an etching mask patterned so as to define the section designed for the pillars 36 (e.g., one of the sections previously described and illustrated in Figures 2A-2D).

Alternatively to what has been represented in Figure and described, the conductive tracks 81, 83 may extend laterally to the pillars 36, in lateral electrical contact with the pillars 36, and not therebelow. In this case, the conductive tracks 81, 83 may be formed in a different manufacturing step with respect to what has been illustrated.

Then, Figure 5I, the wafer 100 is thinned at the rear side 100b, up to reaching a thickness equal to about 100 µm.

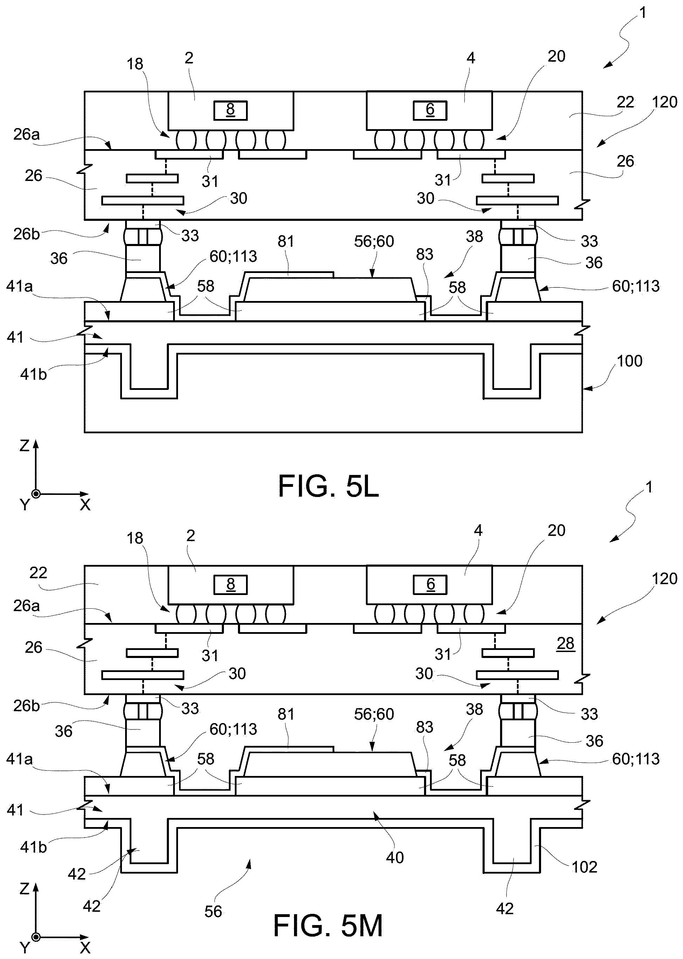

Subsequently, as shown in Figure 5L, the wafer 100 (as processed up to the step of Figure 5I) is physically and electrically coupled to an ASIC assembly 120 through the pillars 36; the ASIC assembly 120 includes the redistribution structure 26 and the first and the second dice 2, 4 coupled to each other by the bumps 18, 20. The ASIC assembly 120 is then arranged overlapped, along the Z axis, on the wafer 100 (in particular above the front side 100a). The steps of manufacturing and mutually coupling the redistribution structure 26 and the dice 2, 4 are not an object of the present invention and are therefore not described. It should also be noted that the ASIC assembly 120 may be purchased already manufactured, and coupled to the pillars 36 by soldering or bonding techniques known per se.

Without any loss of generality, the manufacture of the ASIC assembly 120 may occur by so-called FOWLP- ("fan out wafer level package") type processing techniques. In this regard, the first and the second dice 2, 4 may be manufactured in a per se known manner, adopting so-called wafer-level manufacturing technologies, which indeed allow manufacturing, starting from a same semiconductive wafer (not shown), a plurality of dice, and subsequently separating (singulating) these dice from each other, by dicing operations. After a possible testing step, the dice thus formed are mechanically coupled again, through coupling with the redistribution structure 26, so as to form indeed the ASIC assembly 120. In practice, the ASIC assembly 120 is formed by an assembly of dice fixed to each other, after having been previously singulated, in such a way that this assembly has, as a first approximation, the shape of a wafer (in particular, of the wafer 100), in the sense that it may be superimposed on and coupled to the wafer 100, as described. In other words, the ASIC assembly 120 represents a kind of "reconstructed wafer". Furthermore, the dice of the ASIC assembly 120 share a single redistribution structure 26.

Then, Figure 5M, the wafer 100 is etched at the rear side 100b, to completely remove the material of the wafer 100 up to reaching the etch stop layer 102. The thick portions 42 and the membrane portions 40 are thus formed, separated from each other by the recesses 52. The solid body also comprises, in this example, the etch stop layer 102. However, it is apparent that the etch stop layer 102 may be removed by wet etching, if useful or necessary.

Dicing (singulation) steps may then be performed, in a manner not illustrated. In particular, the scribe lines extend laterally to the pillars 36, i.e. in a zone of the wafer 100 which does not have membranes 40, nor actuators 56, nor pillars 36, and is also external to the overlapping region (along the Z axis) between the wafer 100 and the ASIC assembly 120.

The advantages that the present manufacturing process affords are clear from the previous description.

In particular, the device of the present invention is capable of reaching, during use, high vibration frequencies (about 10 MHz) without compromising the performances.

Finally, it is clear that modifications and variations may be made to the manufacturing process described and illustrated herein, without thereby departing from the scope of the present invention, as defined in the attached claims.

For example, each electroacoustic device may comprise a different number of dice from what has been shown, in which case the manufacturing process modifies accordingly. The transmission and reception circuits may be formed in different dice; in this case, the transmission and reception circuits may be formed by using different technologies.

In general, the actuators may be of a different type with respect to what has been described. For example, the actuators may implement an electrostatic, rather than a piezoelectric, actuation mechanism. Similarly, also the arrangement of the actuators with respect to the corresponding membranes may be different from what has been described.

Furthermore, in lieu of the bumps 18, 20 other conductive connection elements may be used, such as for example corresponding pillars. More generally, all the conductive connection elements described herein are purely exemplary.

Furthermore, each pillar 36 may be, in general, a hypocycloid with a number of cusps equal to or greater than three (e.g., five).

Furthermore, the shape of each pillar 36 may be different for pillars 36 which are different from each other.

## Claims

1. A MEMS device (1) comprising:
- a signal processing assembly (120);
- a transduction module (38) comprising a plurality of transducer devices (56) mutually arranged to form an arrangement pattern of transducer devices (56) adjacent to each other and separated from each other by surface regions of the transduction module (38);
- a stiffening structure (113) at said surface regions of the transduction module, at least partially surrounding each transducer device (56) of said plurality of transducer devices (56);
- a plurality of conductive coupling elements (36) extending on the stiffening structure (113) and configured to physically and electrically couple the transduction module (38) to the signal processing assembly (120), each conductive coupling element (36) being physically separated and electrically insulated from the other conductive coupling elements (36);
- a plurality of first conductive tracks (81; 83), each of them electrically connected to a transducer device (56) and to a respective conductive coupling element (36),
**characterized in that** said conductive coupling elements have a respective section with a shape such as to maximize the overlapping surface with the stiffening structure (113) about the respective transducer device (56).

2. The device according to claim 1, wherein said conductive coupling elements (36) have a section with a shape of: hypocycloid, with a number of cusps equal to or greater than three; triangular; quadrangular.

3. The device according to claim 1 or 2, wherein said arrangement pattern is of matrix or honeycomb type.

4. The device according to claim 3, wherein:
when said arrangement pattern is of matrix type, the matrix includes rows and columns, each transducer device (56) being arranged at the intersection of a respective row and a respective column of said matrix, and wherein each transducer device (56) is surrounded by four conductive coupling elements (36);
when said arrangement pattern is of honeycomb type, each transducer device (56) is surrounded by six conductive coupling elements (36).

5. The device according to any of the preceding claims, wherein each transducer device (56) includes a respective membrane (40) and a respective transducer element integral with said respective membrane (40),
wherein each transducer element is electrically controllable by the signal processing assembly (120) to cause a deformation of the corresponding membrane (40).

6. The device according to claim 5, wherein each transducer element (56) comprises a multilayer, or stack, (60) including:
- a bottom electrode (62), of conductive material;
- a piezoelectric layer (64) on, and in electrical contact with, the bottom electrode; and
- a top electrode (66), on the piezoelectric layer and in electrical contact with the piezoelectric layer,
wherein a respective first conductive track (81) between said plurality of first conductive tracks, is in electrical contact with the top electrode (66) and with a respective conductive coupling element (36).

7. The device according to claim 6, wherein said bottom electrode (62) is an electrode shared between said plurality of transducer elements (56),
further comprising a second conductive track further with respect to said plurality of first conductive tracks (81; 83), the second conductive track being coupled to said bottom electrode (62) and to a conductive coupling element (36) further with respect to said plurality of conductive coupling elements (36).

8. The device according to claim 6 or 7, wherein said multilayer (60) further comprises an insulating layer (68) on the top electrode (66),
and wherein the stiffening structure (113) comprises said multilayer (60).

9. The device according to claim 6, further comprising a plurality of second conductive tracks (83; 81), each of said second conductive tracks being electrically coupled to a respective bottom electrode (62) and to a respective conductive coupling element (36).

10. The device according to claim 1, wherein the stiffening structure (113) completely surrounds each transducer device (56), and wherein each conductive coupling element (36) completely surrounds a respective transducer device (56).

11. The device according to claim 1, wherein the conductive coupling elements (36) are equal in number to two,
and wherein, for each transducer device (56), one of the two conductive coupling elements (36) has a section having a shape of: hypocycloid, with a number of cusps equal to or greater than three; triangular; quadrangular,
and wherein the other of the two conductive coupling elements (36) has a section such as to maximize the overlapping surface with the stiffening structure (113) around the respective transducer device (56), where the stiffening structure is free from said one conductive coupling element (36).

12. The device according to any of the preceding claims, wherein the conductive coupling elements (36) have an elongated shape with an extension direction along an axis (Z), said section being taken on a plane (XY) orthogonal to said axis (Z).

13. The device according to any of the preceding claims, wherein the stiffening structure (113) is a multilayer having a thickness comprised between 1 µm and 50 µm.

14. The device according to any of the preceding claims, wherein the signal processing assembly (120) comprises a redistribution structure (26) provided with a first side (26a) and a second side (26b) opposite to each other, and with redistribution conductive paths (30) which extend between the first side and the second side,
wherein the redistribution structure (26) faces the transduction module (38) by the second side (26b) and is provided, at the second side, with connection pads (33) electrically coupled between respective conductive paths (30) and respective conductive coupling elements (36).

15. The device according to claim 14, wherein the signal processing assembly (120) further comprises a control module (2, 4, 22),
said redistribution structure (26) being provided, at the first side, with further connection pads (31) electrically coupled to respective conductive paths (30),
the control module (2, 4, 22) being arranged facing the first side (26a) of the redistribution structure (26) and being electrically coupled to said further connection pads (31) .

16. The device according to claim 15, wherein the conductive coupling elements (36), the connection pads (33), the redistribution conductive paths (30), and the further connection pads (31) form a plurality of conductive paths configured to carry electrical signals between the control module (2, 4, 22) and the transduction module (38).

17. The device according to any of the preceding claims, wherein said MEMS device (1) is an ultrasound transducer device, or PMUT.

18. A method of manufacturing a MEMS device, comprising the steps of:
- forming a transduction module (38), comprising forming a plurality of transducer devices (56) mutually arranged according to an arrangement pattern of transducer devices (56) adjacent to each other and separated from each other by surface regions of the transduction module (38);
- forming a stiffening structure (113) at said surface regions of the transduction module, at least partially surrounding each transducer device (56) of said plurality of transducer devices (56);
- forming a plurality of conductive coupling elements (36) on the stiffening structure (113), each conductive coupling element (36) being configured to physically and electrically couple the transduction module (38) to the signal processing assembly (120), and being physically separated and electrically insulated from the other conductive coupling elements (36);
- forming a plurality of first conductive tracks (81; 83), each of them electrically connected to a transducer device (56) and to a respective conductive coupling element (36);
- coupling a signal processing assembly (120) to said plurality of conductive coupling elements (36),
**characterized in that** said conductive coupling elements (36) have a section with a shape such as to maximize the overlapping surface with the stiffening structure (113) around the respective transducer device (56).

19. The method according to claim 18, wherein forming each transducer device (56) includes forming a respective membrane (40) and a respective transducer element integral with said respective membrane (40),
and wherein forming each respective membrane includes:
- forming, in a semiconductor body (100), an etch stop layer (102);
- forming, on the etch stop layer, a structural layer (110);
- forming, on the structural layer, an insulation layer (112);
- forming, on the insulation layer, said respective transducer element (56) and said first connection pads associated with said respective transducer element (56), the first connection pads being arranged laterally to the respective transducer element (56);
- removing selective portions of the insulation layer which extend between the transducer element (56) and the first connection pads; and
- completely removing the semiconductor body (100) exposing the etch stop layer (102).

20. The method according to claim 19, further comprising the step of forming supports (42) for each membrane (40), including the steps of:
- forming a respective trench (104) in the semiconductor body, said trench externally delimiting the shape of the respective membrane (40) and having a closed circular or polygonal shape;
- forming the etch stop layer (102) on the semiconductor body and in said trench (104); and
- forming the structural layer (110) on the etch stop layer (102) which extends both on the semiconductor body and in said trench.

## Patentansprüche

1. MEMS-Vorrichtung (1), die Folgendes umfasst:
- eine Signalverarbeitungsbaugruppe (120);
- ein Transduktionsmodul (38), das eine Vielzahl von Wandlervorrichtungen (56) umfasst, die so zueinander angeordnet sind, dass sie ein Anordnungsmuster von Wandlervorrichtungen (56) nebeneinander bilden und durch Oberflächenbereiche des Transduktionsmoduls (38) voneinander getrennt sind;
- eine Versteifungsstruktur (113) an den Oberflächenbereichen des Transduktionsmoduls, die jede Wandlervorrichtung (56) der Vielzahl von Wandlervorrichtungen (56) mindestens teilweise umgibt;
- eine Vielzahl von leitfähigen Koppelelementen (36), die sich über die Versteifungsstruktur (113) erstrecken und so konfiguriert sind, dass sie das Transduktionsmodul (38) physisch und elektrisch mit der Signalverarbeitungsbaugruppe (120) koppeln, wobei jedes leitfähige Koppelelement (36) von den anderen leitfähigen Koppelelementen (36) physisch getrennt und elektrisch isoliert ist;
- eine Vielzahl von ersten leitfähigen Bahnen (81; 83), von denen jede elektrisch mit einer Wandlervorrichtung (56) und mit einem jeweiligen leitfähigen Koppelelement (36) verbunden ist,
**dadurch gekennzeichnet, dass** die leitfähigen Koppelelemente einen jeweiligen Querschnitt mit einer Form aufweisen, die die Überlappungsfläche mit der Versteifungsstruktur (113) um die jeweilige Wandlervorrichtung (56) herum maximiert.

2. Vorrichtung nach Anspruch 1, wobei die leitfähigen Koppelelemente (36) einen Querschnitt mit einer folgenden Form aufweisen: hypozykloid, mit einer Anzahl von Spitzen, die gleich oder größer drei ist; dreieckig; viereckig.

3. Vorrichtung nach Anspruch 1 oder 2, wobei das Anordnungsmuster vom Matrix- oder Wabentyp ist.

4. Vorrichtung nach Anspruch 3, wobei:
wenn das Anordnungsmuster vom Matrixtyp ist, die Matrix Zeilen und Spalten umfasst, wobei jede Wandlervorrichtung (56) an dem Schnittpunkt einer jeweiligen Zeile und einer entsprechenden Spalte der Matrix angeordnet ist, und wobei jede Wandlervorrichtung (56) von vier leitfähigen Koppelelementen (36) umgeben ist;
wenn das Anordnungsmuster vom Wabentyp ist, ist jede Wandlervorrichtung (56) von sechs leitfähigen Koppelelementen (36) umgeben.

5. Vorrichtung nach einem der vorhergehenden Ansprüche, wobei jede Wandlervorrichtung (56) eine jeweilige Membran (40) und ein jeweiliges mit der jeweiligen Membran (40) integriertes Wandlerelement umfasst,
wobei jedes Wandlerelement von der Signalverarbeitungsbaugruppe (120) elektrisch steuerbar ist, um eine Verformung der entsprechenden Membran (40) zu verursachen.

6. Vorrichtung nach Anspruch 5, wobei jedes Wandlerelement (56) eine Mehrschicht oder einen Stapel (60) umfasst, die bzw. der Folgendes enthält:
- eine untere Elektrode (62) aus leitfähigem Material;
- eine piezoelektrische Schicht (64) auf und in elektrischem Kontakt mit der unteren Elektrode; und
- eine obere Elektrode (66), auf der piezoelektrischen Schicht und in elektrischem Kontakt mit der piezoelektrischen Schicht,
wobei eine jeweilige erste leitfähige Bahn (81) zwischen der Vielzahl von ersten leitfähigen Bahnen in elektrischem Kontakt mit der oberen Elektrode (66) und mit einem jeweiligen leitfähigen Koppelelement (36) steht.

7. Vorrichtung nach Anspruch 6, wobei die untere Elektrode (62) eine Elektrode ist, die von der Vielzahl von Wandlerelementen (56) gemeinsam genutzt wird,
ferner umfassend eine zweite leitfähige Bahn, die sich ferner in Bezug auf die Vielzahl von ersten leitfähigen Bahnen (81; 83) befindet, wobei die zweite leitfähige Bahn mit der unteren Elektrode (62) und mit einem leitfähigen Koppelelement (36) gekoppelt ist, das sich ferner in Bezug auf die Vielzahl von leitfähigen Koppelelemente (36) befindet.

8. Vorrichtung nach Anspruch 6 oder 7, wobei die Mehrschicht (60) ferner eine Isolierschicht (68) auf der oberen Elektrode (66) umfasst,
und wobei die Versteifungsstruktur (113) die Mehrschicht (60) umfasst.

9. Vorrichtung nach Anspruch 6, ferner umfassend eine Vielzahl von zweiten leitfähigen Bahnen (83;81), wobei jede der zweiten leitfähigen Bahnen elektrisch mit einer jeweiligen unteren Elektrode (62) und mit einem jeweiligen leitfähigen Koppelelement (36) gekoppelt ist.

10. Vorrichtung nach Anspruch 1, wobei die Versteifungsstruktur (113) jede Wandlervorrichtung (56) vollständig umgibt, und wobei jedes leitfähige Koppelelement (36) eine jeweilige Wandlervorrichtung (56) vollständig umgibt.

11. Vorrichtung nach Anspruch 1, wobei die leitfähigen Koppelelemente (36) in ihrer Anzahl gleich zwei sind,
und wobei für jede Wandlervorrichtung (56) eines der beiden leitfähigen Koppelelemente (36) einen Querschnitt aufweist, der eine folgende Form aufweist: hypozykloid, mit einer Anzahl von Spitzen, die gleich oder größer drei ist; dreieckig; quadratisch,
und wobei das andere der beiden leitfähigen Koppelelemente (36) einen Querschnitt aufweist, der die überlappende Oberfläche mit der Versteifungsstruktur (113) um die jeweilige Wandlervorrichtung (56) herum maximiert, wobei die Versteifungsstruktur frei von dem einen leitfähigen Koppelelement (36) ist.

12. Vorrichtung nach einem der vorhergehenden Ansprüche, wobei die leitfähigen Koppelelemente (36) eine längliche Form mit einer Ausdehnungsrichtung entlang einer Achse (Z) aufweisen, wobei der Querschnitt auf einer Ebene (XY) orthogonal zu der Achse (Z) genommen wird.

13. Vorrichtung nach einem der vorhergehenden Ansprüche, wobei die Versteifungsstruktur (113) eine Mehrschicht mit einer Dicke zwischen 1 µm und 50 µm ist.

14. Vorrichtung nach einem der vorhergehenden Ansprüche, wobei die Signalverarbeitungsbaugruppe (120) eine Umverteilungsstruktur (26) umfasst, die mit einer ersten Seite (26a) und einer zweiten Seite (26b), die einander gegenüberliegen, und mit leitfähigen Umverteilungspfaden (30) versehen ist, die sich zwischen der ersten Seite und der zweiten Seite erstrecken,
wobei die Umverteilungsstruktur (26) mit der zweiten Seite (26b) dem Transduktionsmodul (38) zugewandt ist und auf der zweiten Seite mit Verbindungspads (33) versehen ist, die elektrisch zwischen den jeweiligen leitfähigen Pfaden (30) und den jeweiligen leitfähigen Koppelelementen (36) gekoppelt sind.

15. Vorrichtung nach Anspruch 14, wobei die Signalverarbeitungsbaugruppe (120) ferner ein Steuermodul (2, 4, 22) umfasst,
wobei die Umverteilungsstruktur (26) auf der ersten Seite mit weiteren Verbindungspads (31) versehen ist, die elektrisch mit den jeweiligen leitfähigen Pfaden (30) gekoppelt sind,
wobei das Steuermodul (2, 4, 22) so angeordnet ist, dass es der ersten Seite (26a) der Umverteilungsstruktur (26) zugewandt ist, und
elektrisch mit den weiteren Verbindungspads (31) gekoppelt ist.

16. Vorrichtung nach Anspruch 15, wobei die leitfähigen Koppelelemente (36), die Verbindungspads (33), die leitfähigen Umverteilungspfade (30) und die weiteren Verbindungspads (31) eine Vielzahl von leitfähigen Pfaden bilden, die so konfiguriert sind, dass sie elektrische Signale zwischen dem Steuermodul (2, 4, 22) und dem Transduktionsmodul (38) übertragen.

17. Vorrichtung nach einem der vorhergehenden Ansprüche, wobei die MEMS-Vorrichtung (1) eine Ultraschallwandlervorrichtung oder PMUT ist.

18. Verfahren zum Herstellen einer MEMS-Vorrichtung, das die folgenden Schritte umfasst:
- Bilden eines Transduktionsmoduls (38), umfassend das Bilden einer Vielzahl von Wandlervorrichtungen (56), die entsprechend einem Anordnungsmuster von Wandlervorrichtungen (56) einander benachbart angeordnet und durch Oberflächenbereiche des Transduktionsmoduls (38) voneinander getrennt sind;
- Bilden einer Versteifungsstruktur (113) an den Oberflächenbereichen des Transduktionsmoduls, die jede Wandlervorrichtung (56) der Vielzahl von Wandlervorrichtungen (56) mindestens teilweise umgibt;
- Bilden einer Vielzahl von leitfähigen Koppelelementen (36) auf der Versteifungsstruktur (113), wobei jedes leitfähige Koppelelement (36) so konfiguriert ist, dass es das Transduktionsmodul (38) physisch und elektrisch mit der Signalverarbeitungsbaugruppe (120) koppelt, und es physisch von den anderen leitfähigen Koppelelementen (36) getrennt und elektrisch isoliert ist;
- Bilden einer Vielzahl von ersten leitfähigen Bahnen (81; 83), von denen jede elektrisch mit einer Wandlervorrichtung (56) und mit einem jeweiligen leitfähigen Koppelelement (36) verbunden ist;
- Koppeln einer Signalverarbeitungsbaugruppe (120) an die Vielzahl von leitfähigen Koppelelementen (36),
**dadurch gekennzeichnet, dass** die leitfähigen Koppelelemente (36) einen Querschnitt mit einer Form aufweisen, die die Überlappungsfläche mit der Versteifungsstruktur (113) um die jeweilige Wandlervorrichtung (56) herum maximiert.

19. Verfahren nach Anspruch 18, wobei das Bilden jeder Wandlervorrichtung (56) das Bilden einer jeweiligen Membran (40) und eines jeweiligen mit der jeweiligen Membran (40) integrierten Wandlerelements umfasst,
und wobei das Bilden jeder jeweiligen Membran Folgendes enthält:
- Bilden einer Ätzstoppschicht (102) in einem Halbleiterkörper (100);
- Bilden einer Strukturschicht (110) auf der Ätzstoppschicht;
- Bilden einer Isolationsschicht (112) auf der Strukturschicht;
- Bilden, auf der Isolationsschicht, des jeweiligen Wandlerelements (56) und der ersten Verbindungspads, die mit dem jeweiligen Wandlerelement (56) verbunden sind, wobei die ersten Verbindungspads seitlich zu dem jeweiligen Wandlerelement (56) angeordnet sind;
- Entfernen selektiver Abschnitte der Isolationsschicht, die sich zwischen dem Wandlerelement (56) und den ersten Verbindungspads erstrecken; und
- vollständiges Entfernen des Halbleiterkörpers (100), wodurch die Ätzstoppschicht (102) freigelegt wird.

20. Verfahren nach Anspruch 19, ferner umfassend den Schritt des Bildens von Trägern (42) für jede Membran (40), einschließlich der folgenden Schritte:
- Bilden eines jeweiligen Grabens (104) in dem Halbleiterkörper, wobei der Graben die Form der jeweiligen Membran (40) äußerlich begrenzt und eine geschlossene kreisförmige oder polygonale Form aufweist;
- Bilden der Ätzstoppschicht (102) auf dem Halbleiterkörper und in dem Graben (104); und
- Bilden der Strukturschicht (110) auf der Ätzstoppschicht (102), die sich sowohl auf dem Halbleiterkörper als auch in dem Graben erstreckt.

## Revendications

1. Dispositif MEMS (1) comprenant :
- un ensemble de traitement de signal (120) ;
- un module de transduction (38) comprenant une pluralité de dispositifs transducteurs (56) agencés mutuellement pour former un motif d'agencement de dispositifs transducteurs (56) adjacents les uns aux autres et séparés les uns des autres par des régions de surface du module de transduction (38) ;
- une structure de raidissement (113) au niveau desdites régions de surface du module de transduction, entourant au moins partiellement chaque dispositif transducteur (56) de ladite pluralité de dispositifs transducteurs (56) ;
- une pluralité d'éléments de couplage conducteurs (36) s'étendant sur la structure de raidissement (113) et configurés pour coupler physiquement et électriquement le module de transduction (38) à l'ensemble de traitement de signal (120), chaque élément de couplage conducteur (36) étant physiquement séparé et isolé électriquement des autres éléments de couplage conducteurs (36) ;
- une pluralité de premières pistes conductrices (81 ; 83), chacune d'entre elles étant connectée électriquement à un dispositif transducteur (56) et à un élément de couplage conducteur (36) respectif,
**caractérisé en ce que** lesdits éléments de couplage conducteurs ont une section respective ayant une forme telle qu'elle maximise la surface de chevauchement avec la structure de raidissement (113) autour du dispositif transducteur (56) respectif.

2. Dispositif selon la revendication 1, dans lequel lesdits éléments de couplage conducteurs (36) ont une section de forme : hypocycloïde, avec un nombre de points de rebroussement égal ou supérieur à trois ; triangulaire ; quadrangulaire.

3. Dispositif selon la revendication 1 ou 2, dans lequel ledit motif d'agencement est de type matrice ou nid d'abeilles.

4. Dispositif selon la revendication 3, dans lequel :
lorsque ledit motif d'agencement est de type matrice, la matrice comporte des rangées et des colonnes, chaque dispositif transducteur (56) étant agencé à l'intersection d'une rangée respective et d'une colonne respective de ladite matrice, et dans lequel chaque dispositif transducteur (56) est entouré de quatre éléments de couplage conducteurs (36) ;
lorsque ledit motif d'agencement est de type nid d'abeilles, chaque dispositif transducteur (56) est entouré de six éléments de couplage conducteurs (36).

5. Dispositif selon l'une quelconque des revendications précédentes, dans lequel chaque dispositif transducteur (56) comporte une membrane (40) respective et un élément transducteur respectif solidaire de ladite membrane (40) respective,
dans lequel chaque élément transducteur peut être électriquement commandé par l'ensemble de traitement de signal (120) pour provoquer une déformation de la membrane (40) correspondante.

6. Dispositif selon la revendication 5, dans lequel chaque élément transducteur (56) comprend une multicouche, ou empilement, (60) comportant :
- une électrode inférieure (62), constituée de matériau conducteur ;
- une couche piézoélectrique (64) sur, et en contact électrique avec, l'électrode inférieure ; et
- une électrode supérieure (66), sur la couche piézoélectrique et en contact électrique avec la couche piézoélectrique,
dans lequel une première piste conductrice (81) respective entre ladite pluralité de premières pistes conductrices est en contact électrique avec l'électrode supérieure (66) et avec un élément de couplage conducteur (36) respectif.

7. Dispositif selon la revendication 6, dans lequel ladite électrode inférieure (62) est une électrode partagée entre ladite pluralité d'éléments transducteurs (56),
comprenant en outre une seconde piste conductrice en outre en rapport avec ladite pluralité de premières pistes conductrices (81 ; 83), la seconde piste conductrice étant couplée à ladite électrode inférieure (62) et à un élément de couplage conducteur (36) en outre en rapport avec ladite pluralité d'éléments de couplage conducteurs (36).

8. Dispositif selon la revendication 6 ou 7, dans lequel ladite multicouche (60) comprend en outre une couche isolante (68) sur l'électrode supérieure (66),
et dans lequel la structure de raidissement (113) comprend ladite multicouche (60).

9. Dispositif selon la revendication 6, comprenant en outre une pluralité de secondes pistes conductrices (83 ;
81), chacune desdites secondes pistes conductrices étant couplée électriquement à une électrode inférieure (62) respective et à un élément de couplage conducteur (36) respectif.

10. Dispositif selon la revendication 1, dans lequel la structure de raidissement (113) entoure complètement chaque dispositif transducteur (56), et dans lequel chaque élément de couplage conducteur (36) entoure complètement un dispositif transducteur (56) respectif.

11. Dispositif selon la revendication 1, dans lequel les éléments de couplage conducteurs (36) sont égaux en nombre à deux,
et dans lequel, pour chaque dispositif transducteur (56), l'un des deux éléments de couplage conducteurs (36) a une section ayant une forme : hypocycloïde, avec un nombre de points de rebroussement égal ou supérieur à trois ; triangulaire ; quadrangulaire,
et dans lequel l'autre des deux éléments de couplage conducteurs (36) a une section telle qu'elle maximise la surface de chevauchement avec la structure de raidissement (113) autour du dispositif transducteur (56) respectif, où la structure de raidissement est dégagée dudit élément de couplage conducteur (36).

12. Dispositif selon l'une quelconque des revendications précédentes, dans lequel les éléments de couplage conducteurs (36) ont une forme allongée avec une direction d'extension le long d'un axe (Z), ladite section étant prise sur un plan (XY) orthogonal audit axe (Z).

13. Dispositif selon l'une quelconque des revendications précédentes, dans lequel la structure de raidissement (113) est une multicouche ayant une épaisseur comprise entre 1 µm et 50 µm.

14. Dispositif selon l'une quelconque des revendications précédentes, dans lequel l'ensemble de traitement de signal (120) comprend une structure de redistribution (26) dotée d'un premier côté (26a) et d'un second côté (26b) opposés l'un à l'autre, et de chemins conducteurs de redistribution (30) qui s'étendent entre le premier côté et le second côté,
dans lequel la structure de redistribution (26) fait face au module de transduction (38) par le second côté (26b) et est dotée, sur le second côté, de plots de connexion (33) couplés électriquement entre des chemins conducteurs (30) respectifs et des éléments de couplage conducteurs (36) respectifs.

15. Dispositif selon la revendication 14, dans lequel l'ensemble de traitement de signal (120) comprend en outre un module de commande (2, 4, 22),
ladite structure de redistribution (26) étant dotée, sur le premier côté, d'autres plots de connexion (31) couplés électriquement à des chemins conducteurs (30) respectifs, le module de commande (2, 4, 22) étant agencé en faisant face au premier côté (26a) de la structure de redistribution (26) et
étant couplé électriquement auxdits autres plots de connexion (31).

16. Dispositif selon la revendication 15, dans lequel les éléments de couplage conducteurs (36), les plots de connexion (33), les chemins conducteurs de redistribution (30) et les autres plots de connexion (31) forment une pluralité de chemins conducteurs configurés pour transporter des signaux électriques entre le module de commande (2, 4, 22) et le module de transduction (38).

17. Dispositif selon l'une quelconque des revendications précédentes, dans lequel ledit dispositif MEMS (1) est un dispositif transducteur à ultrasons, ou PMUT.

18. Procédé de fabrication d'un dispositif MEMS, comprenant les étapes consistant à :
- former un module de transduction (38), comprenant la formation d'une pluralité de dispositifs transducteurs (56) agencés mutuellement selon un motif d'agencement de dispositifs transducteurs (56) adjacents les uns aux autres et séparés les uns des autres par des régions de surface du module de transduction (38) ;
- former une structure de raidissement (113) au niveau desdites régions de surface du module de transduction, entourant au moins partiellement chaque dispositif transducteur (56) de ladite pluralité de dispositifs transducteurs (56) ;
- former une pluralité d'éléments de couplage conducteurs (36) sur la structure de raidissement (113), chaque élément de couplage conducteur (36) étant configuré pour coupler physiquement et
électriquement le module de transduction (38) à l'ensemble de traitement de signal (120), et étant physiquement séparé et isolé électriquement des autres éléments de couplage conducteurs (36) ;
- former une pluralité de premières pistes conductrices (81 ; 83), chacune d'entre elles étant connectée électriquement à un dispositif transducteur (56) et à un élément de couplage conducteur (36) respectif ;
- coupler un ensemble de traitement de signal (120) à ladite pluralité d'éléments de couplage conducteurs (36), **caractérisé en ce que** lesdits éléments de couplage conducteurs (36) ont une section ayant une forme telle qu'elle maximise la surface de chevauchement avec la structure de raidissement (113) autour du dispositif transducteur (56) respectif.

19. Procédé selon la revendication 18, dans lequel la formation de chaque dispositif transducteur (56) comporte la formation d'une membrane (40) respective et d'un élément transducteur respectif solidaire de ladite membrane (40) respective,
et dans lequel la formation de chaque membrane respective comporte :
- la formation, dans un corps semi-conducteur (100), d'une couche d'arrêt de gravure (102) ;
- la formation, sur la couche d'arrêt de gravure, d'une couche structurelle (110) ;
- la formation, sur la couche structurelle, d'une couche d'isolation (112) ;
- la formation, sur la couche d'isolation, dudit élément transducteur (56) respectif et desdits premiers plots de connexion associés audit élément transducteur (56) respectif, les premiers plots de connexion étant agencés latéralement par rapport à l'élément transducteur (56) respectif ;
- le retrait de portions sélectives de la couche d'isolation qui s'étendent entre l'élément transducteur (56) et les premiers plots de connexion ; et
- le retrait complet du corps semi-conducteur (100) en exposant la couche d'arrêt de gravure (102).

20. Procédé selon la revendication 19, comprenant en outre l'étape de formation de supports (42) pour chaque membrane (40), comportant les étapes consistant à :
- former une tranchée (104) respective dans le corps semi-conducteur, ladite tranchée délimitant extérieurement la forme de la membrane (40) respective et présentant une forme circulaire ou polygonale fermée ;
- former la couche d'arrêt de gravure (102) sur le corps semi-conducteur et dans ladite tranchée (104) ; et
- former la couche structurelle (110) sur la couche d'arrêt de gravure (102) qui s'étend à la fois sur le corps semi-conducteur et dans ladite tranchée.
